# EUROPEAN PATENT SPECIFICATION

(11) **EP 0 502 663 B1**
(45) Date of publication and mention of the grant of the patent: **05.09.2001**
(21) Application number: 92301710.7
(22) Date of filing: 28.02.1992
(51) Int. Cl.: H01L 21/76, H01L 21/32

(54) **Semiconductor device processing method providing isolation regions in a semi-conductor substrate**
Verfahren zur Herstellung einer Halbleiteranordnung mit Isolationszonen in einem Halbleitersubstrat
Procédé de fabrication de dispositifs semi-conducteurs comportant des régions d'isolation dans un substrat semi-conducteur

(30) Priority: 04.03.1991 US 663349
(43) Date of publication of application: 09.09.1992
(73) Proprietor: NCR International, Inc., Dayton, Ohio 45479 (US); HYUNDAI ELECTRONICS AMERICA, Milpitas, California 95035 (US); Symbios, Inc., Fort Collins, Colorado 80525 (US)
(72) Inventor: Lee, Steven S., Colorado Springs, Colorado 80906 (US)
(74) Representative: Gill, David Alan

(56) References cited:
- EP-A- 0 052 948
- US-A- 4 580 330
- US-A- 4 923 563
- JOURNAL OF THE ELECTROCHEMICAL SOCIETY vol. 134, no. 6, June 1987, MANCHESTER, NEW HAMPSHIRE US pages 1503 - 1507 K. SAKUMA ET AL

## Description

This invention relates to the manufacture of semiconductor integrated circuit devices.

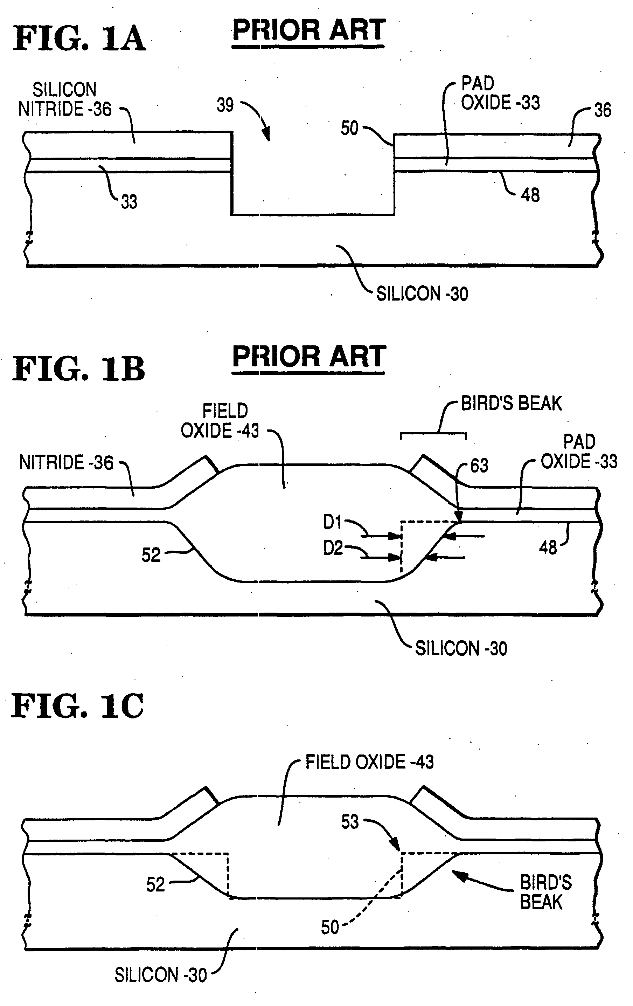

In the fabrication of integrated circuits, a phenomenon known as "bird's beak" sometimes occurs. Figures 1A and 1B illustrate an example. Figure 1A shows four components: a silicon substrate 30, a pad oxide layer 33, a silicon nitride layer 36, and a trench 39 formed in the preceding three components. After trench formation, a field oxide 43 in Figure 1B is thermally grown in the trench, by introducing oxygen at an elevated temperature.

For various technical reasons, the field oxide 43 does not penetrate to a uniform depth into the sidewalls 50 of the silicon in Figure 1A. Instead, the incoming oxygen (which forms the oxide 43) diffuses deeper in the vicinity of the interface 48 between the pad oxide and silicon. For example, oxide depth D1 in Figure 1B is deeper than depth D2. Moreover, in general, the change in depth is not linear: profile 52 is a curved line.

The profile 52 of the oxide structure is known as a bird's beak. Bird's beaks are undesirable because they occupy space which could otherwise be used for circuit elements, such as transistors.

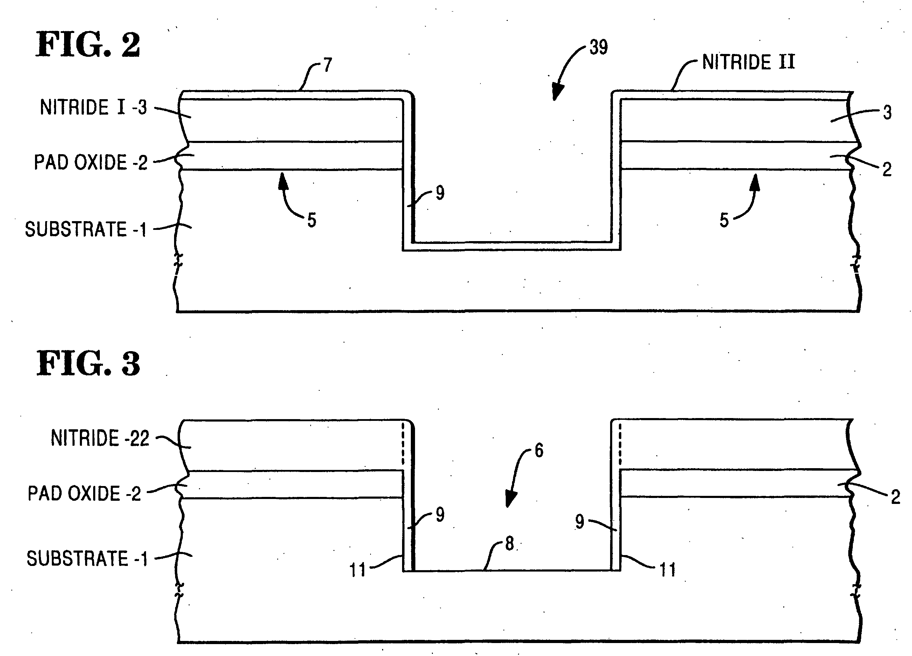

One solution to the formation of bird's beaks is disclosed in U.S. patent 4,923,563. Figures 2, 3, 4A, 4B, and 5 herein are copied from the patent, but with some numerals added for reference.

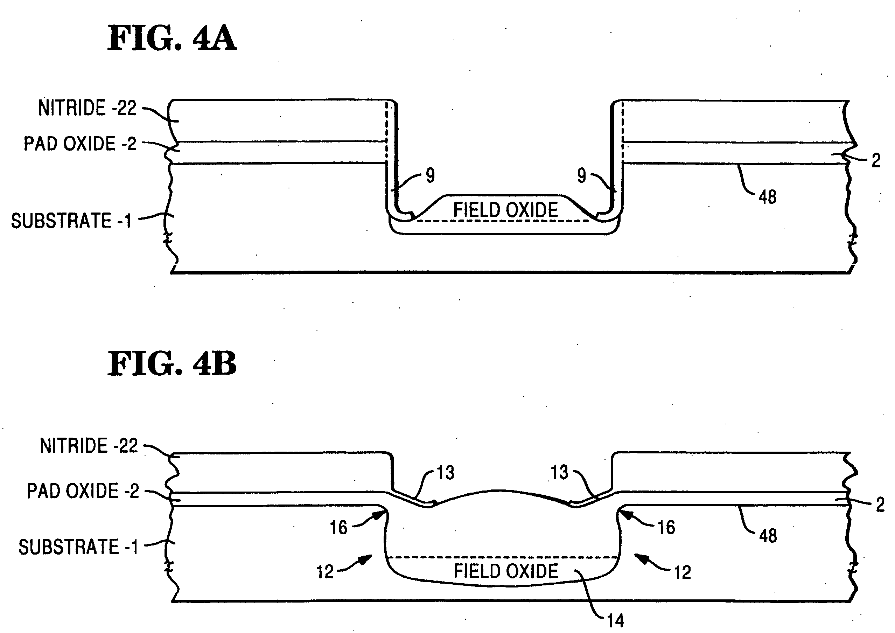

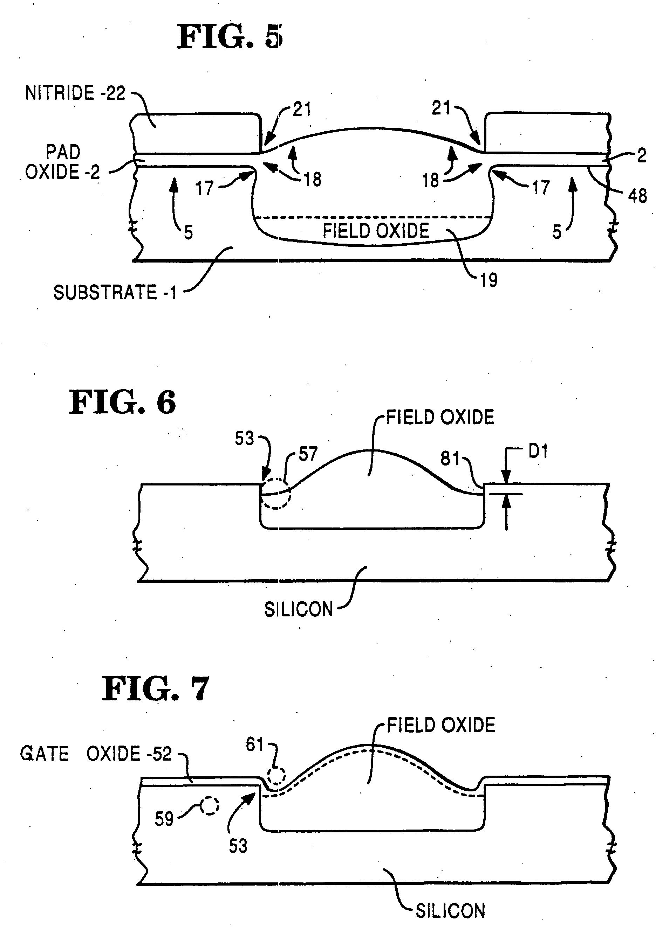

In Figure 2, a trench 39 is created similar to that of Figure 1A. Next, a nitride layer 7, having sidewalls 9, is applied by low pressure chemical vapor deposition. Next, as shown in Figure 3, the bottom of the nitride layer 7 is removed, exposing the underlying silicon at the trench bottom 8. Then, as shown by the sequence of Figures 4A, 4B, and 5, field oxide is grown in the trench. However, oxide invasion into the interface 48 does not occur to a significant extent at this time, because the sidewall nitride layer 9 covers the edge of the interface and inhibits oxygen penetration. A large bird's beak is not formed as in Figure 1B.

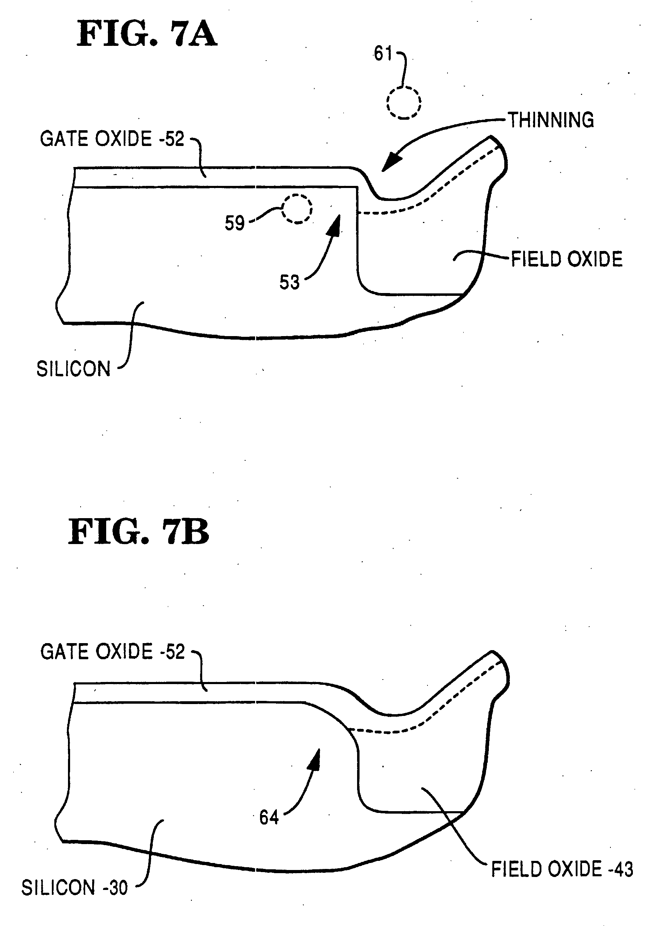

In some situations, the approach described above in reducing bird's beaks can result in a disadvantage. One example is shown in Figures 6 and 7. The structure of Figure 6 was derived by etching away the pad oxide of Figure 5. During the etching process, some field oxide is also etched away, as in region 57. If a bird's beak in Figure 1C is not present, the sloped profile 52 is not present, so that etching of the field oxide can result in a sharp corner 53, in Figures 1C and 6, where the field oxide meets the silicon. When gate oxide 52 in Figure 7 is formed over the corner 53, the corner can cause the gate oxide to be formed in an undesirably thin layer, as indicated in Figure 7A. The thin gate oxide can structurally fail, and cease to act as an electrical insulator, allowing regions 59 and 61 in Figures 7 and 7A to come into electrical contact, which is undesirable.

US Patent 4580330 discloses a method of fabricating an integrated circuit device in which a recess is formed in a silicon substrate and a sidewall pad oxide layer is formed on the sides of the said recess and so as to extend over a corner formed in the substrate and into an undercut formed in an oxide layer overlying said substrate. The method serves merely to obtain a secure joint between a first nitride layer formed above the oxide layer and a sidewall nitride layer formed over the sidewalls of the recess.

It is an object of the present invention to provide a process for integrated circuit manufacture in which bird's beaks may be reduced without causing a structural configuration which induces thinning of a subsequently formed layer formed at the location prone to bird's beak formation.

Therefore, according to the present invention, there is provided a method of processing a semiconductor device having a silicon substrate, comprising the steps of forming a pad oxide layer on said substrate, forming a trench through said pad oxide layer and into said silicon substrate, blunting the comer of the silicon substrate found at the sidewall of the trench at the point of interface between the silicon substrate and said pad oxide layer by the formation of rounding oxide at said region, forming a silicon nitride protection layer to extend over said rounding oxide at said region, exposing the base of said trench and thermally growing field oxide in said trench, exposing said blunted comer and forming an oxide layer to extend over said blunted corner, the method comprising the step of, prior to said step of forming said silicon nitride protection layer, partially removing said layer of rounding oxide from the side walls of said trench to form substantially planar and parallel surfaces of the rounding oxide on the side walls of the trench.

One embodiment of the invention will now be described by way of example, with reference to the accompanying drawings, in which:-

Figures 1A and 1B show an intermediate structure in the fabrication of an electronic integrated circuit, and Figure 1B shows a bird's beak.

Figure 1C shows a sharp corner 53 can exist when a bird's beak in Figure 1B is prevented from forming.

Figures 2, 3, 4A, 4B, and 5 illustrate steps which inhibit formation of a bird's beak.

Figure 6 illustrates that the sharp corner 53 in Figure 1C can be exposed during a fabrication step.

Figure 7 illustrates formation of a gate oxide layer 52 over the sharp corner 53 of Figure 6.

Figure 7A illustrates how the sharp corner 53 can cause the gate oxide of Figure 7 to become thin.

Figure 7B illustrates one form of the invention: the corner of Figure 7A has been rounded.

Figures 8 - 14 illustrate a sequence of steps by which bird's beak can be reduced, yet without formation of the sharp corner 53 in Figure 1C.

Figures 15 - 18 illustrate an alternate procedure to that of Figures 8 - 14.

Figure 19 illustrates an intermediate structure formed by the present invention, which can be derived from the structures of either Figure 14 or 18.

Figure 20 illustrates, in simplified form, how oxide grows in silicon.

Figure 21 illustrates schematically how surface 78 moves perpendicularly during the growth of Figure 20.

Figure 22 illustrates schematically how the perpendicular growth of Figure 21 can, in theory, result in a vacant corner 81 at which no oxide is present.

Figure 23 is an enlargement of the region of the vacant corner 81 of Figure 22.

Figure 24 illustrates a reconfiguration of the corner 53 in Figure 22.

Figure 25 illustrates the corner 53 of Figure 22, and shows the final configuration of oxide formed at the corner.

Figure 26 illustrates how, in simplified theory, material migrates when the corner 53 in Figures 22 and 25 is oxidized.

Figure 27 illustrates a rounded corner which is to be oxidized.

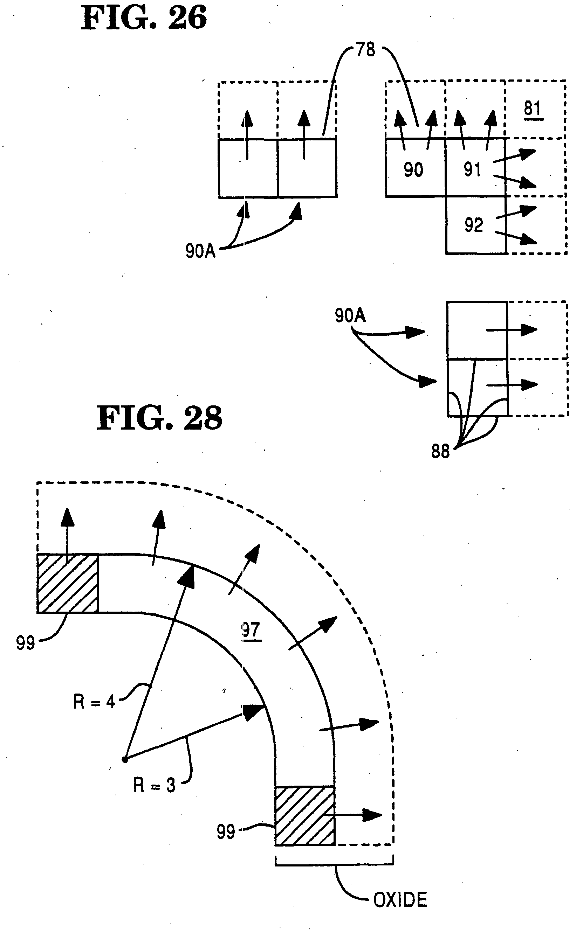

Figure 28 illustrates, in simplified theory, how material migrates during oxidation of the rounded corner of Figure 27.

In simplified terms, a process according to the invention enables the sharp corner 53 shown in Figures 6 and 7A, to be rounded off to create the rounded corner 64 in Figure 7B. The rounding reduces the thinning shown in Figure 7A, and promotes the thicker oxide layer shown in Figure 7B.

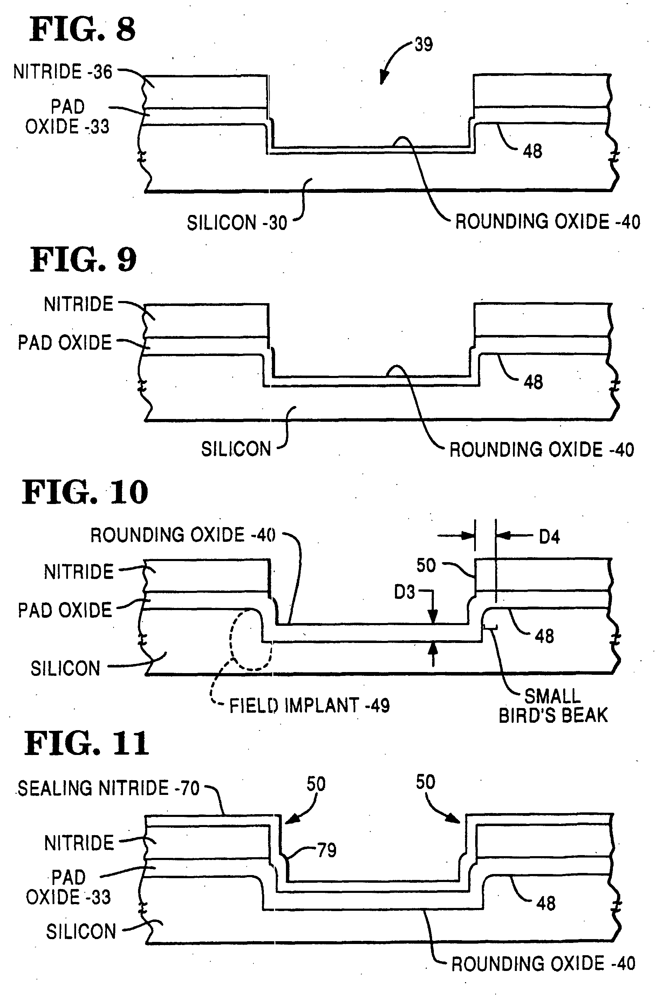

The preferred method can begin with the structure shown in Figure 1A. A layer of silicon dioxide, labelled ROUNDING OXIDE 40, is thermally grown upon the walls of the trench 39, as shown by the sequence of Figures 8 - 10. The ROUNDING OXIDE layer 40 is in the range of about 3 to 150 nanometers thick.

The ROUNDING OXIDE 40 preferentially invades the interface 48, as does field oxide in the case of bird's beak formation. However, because the process of forming the ROUNDING OXIDE 40 is of much shorter duration than that for forming field oxide, the invasion of the interface 48 is much less. For example, if the ROUNDING OXIDE 40 is between about 10 and 80 nanometers thick (thickness is indicated by dimension D3 in Figure 10), the invasion would be expected to be about 8 to 64 nanometers (the invasion is indicated by dimension D4 in Figure 10). Following ROUNDING OXIDE 40 formation, a field implant 49 is undertaken, as indicated in Figure 10, in order to introduce dopants for creation of sources and drains.

After field implantation, one of two alternate procedures can be performed in preparation for formation of field oxide. In the first procedure which relates to the subject matter of the invention but does not illustrated an embodiment thereof, a sealing nitride layer 70 in Figure 11 is deposited over the ROUNDING OXIDE 40 and pad oxide 33. The sealing nitride is in the range of 5 to 250 nanometers in thickness. As described in the Background, the sealing nitride functions primarily to retard invasion the of oxygen into the interface 48 during field oxide growth.

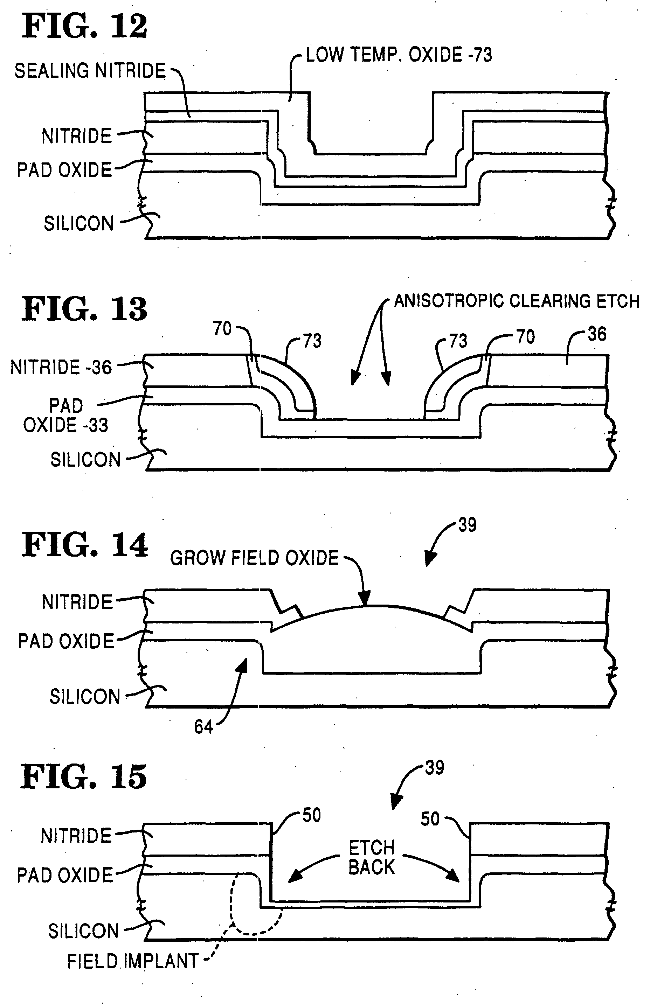

Next, an oxide layer 73 (termed Low Temperature Oxide, LTO) is formed on the nitride layer by a low-temperature process, as shown in Figure 12. The LTO is in the range of 10 to 250 nanometers in thickness. Then, an anisotropic etch clears the bottom of the trench, as shown in Figure 13. Finally, field oxide is thermally grown in the trench 39, as shown in Figure 14, consuming and bending the nitride layers into approximately the configurations shown. A rounded corner 64 is present.

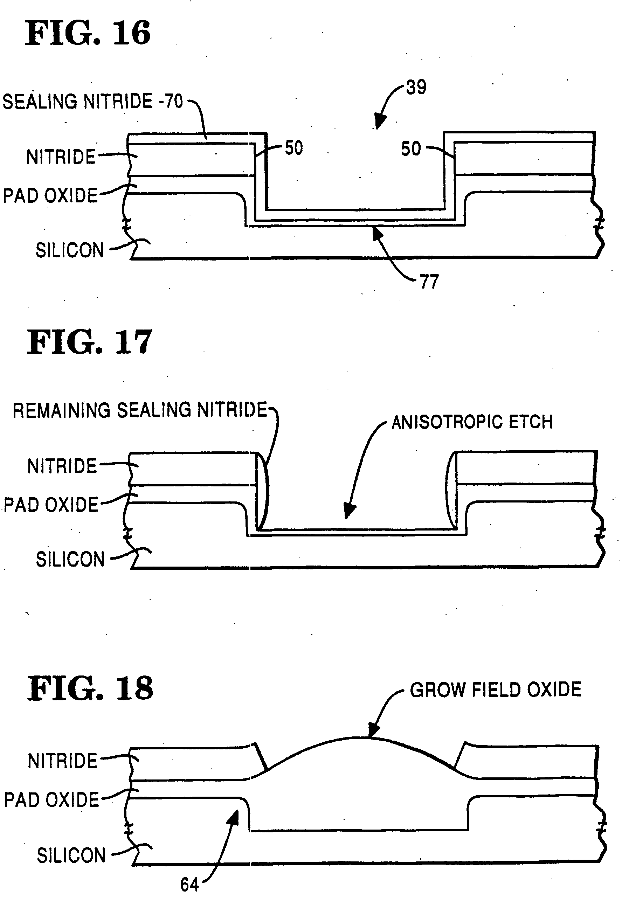

In the alternate procedure, prior to the application of the sealing nitride in Figure 11, the ROUNDING OXIDE 40 layer is partially etched back, as shown in Figure 15, so that the walls 50 form surfaces which are planar and parallel. Protrusions 79 in Figure 11 are now absent. Then, the sealing nitride layer 70 is applied, as shown in Figure 16.

Since the sealing nitride layer 70 is approximately conformal to the etched-back ROUNDING OXIDE 40 layer, the sealing nitride layers on the side walls 50 will likewise be parallel. With such parallel walls in Figure 17, an anisotropic etch of the bottom 77 of the trench 39 can be undertaken without a protective LTO layer. The main reason is that the protrusions such as 79 in Figure 11 are absent: the walls 50 are parallel, so that the incoming ions do not strike the walls 50, but strike only the bottom 77 of the trench 39, etching the materials at the bottom only.

Following the nitride-clearing step of Figure 17, field oxide is grown as shown in Figure 18. Again, as in Figure 13, a rounded corner 64 is present.

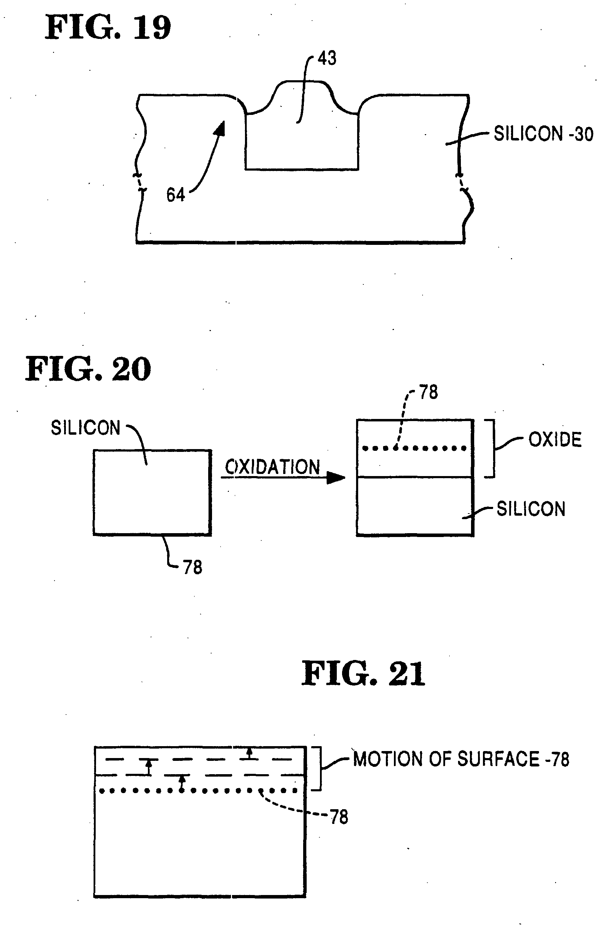

After growth of field oxide, the structure is etched to expose the silicon and the field oxide, providing the structure shown in Figure 19. Gate oxide is deposited, forming the layer indicated in Figure 7B, which lacks the thinning present in Figure 7A, because of the rounded corner 64.

### GENERAL CONSIDERATIONS

1. There are several ways to explain why the invention is effective in mitigating oxide thinning at corners, including the following. The oxide growth occurs when incoming oxygen bonds with silicon and forms a solid structure of silicon dioxide. As a rough approximation, a given number of silicon atoms occupies a volume which is about 44 % of the volume of the same number of atoms after oxidation. That is, one million silicon atoms in a solid state occupy about 44 % of the volume of one million atoms of silicon dioxide. [See pages 343, 344 of S. M. Sze, Semiconductor Devices, Physics and Technology (John Wiley, New York, 1985)] For present purposes, this 44 % quantity will be rounded to 50 % for simplicity: silicon is viewed as doubling in volume when it oxidizes.

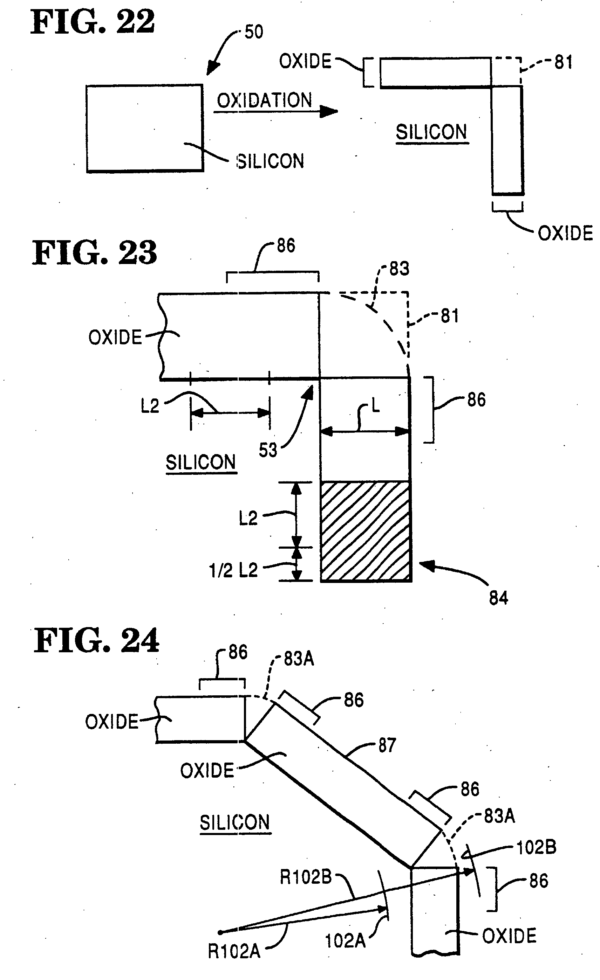

Figure 20 shows oxidation of a silicon surface. The previous surface 78 of silicon becomes located at the center of the oxide (under the 50% assumption). That is, oxidation occurs within the body of the silicon, and the oxidized silicon expands and extends beyond the surface 78. For present purposes, the previous surface 78 can be viewed as moving outward, perpendicular to the previous surface, as indicated by the sequence in Figure 23.

When a square corner oxidizes, such as the corner 53 in Figure 7A, after a given amount of oxidation has occurred, the parallel movement shown in Figure 21 would cause the oxide configuration shown in Figure 22. (Figure 22 is a simplification made for the purposes of explaining why thinning occurs; the configuration of this Figure probably does not actually occur.) Because the oxide surface is assumed to grow perpendicular to the initial silicon surface, there is no oxide formed in square 81; it remains empty. If an oxide layer is to be formed around the corner, the quarter circle 83 in Figure 23 must be filled with oxide. This filling oxide must be donated by neighboring oxide. The donations will cause the thinning discussed above, as the following numerical example will illustrate.

### EXAMPLE 1

Let it be assumed that the layer thickness L in Figure 23 is two nanometers. The area of the quarter circle 83 is thus (pi)(2)²/4, or 3.14 square nanometers. Since each linear nanometer (dimension L2) of the surface is covered by 2 square nanometers of oxide (L2 x L = 2), about 1.5 linear nanometers (ie, 3.14/2) must be depleted and contributed to the quarter circle. Hatched area 84 represents the depleted area. Of course, an entire hatched area is not donated to the quarter circle, but, instead, the donations will be made by several different areas, causing a distributed thinning.

Clearly, filling the quarter circle 83 will cause a thinning in the oxide layer near the corner 53, because neighboring oxide must be depleted and contributed to the quarter circle. Moreover, as the oxide layer becomes thicker, the relative thinning worsens, because the area of the quarter circle 83 increases as the square of layer thickness. An example will illustrate the worsening in relative thinning.

### EXAMPLE 2

If the thickness L is 8 nanometers, instead of the two nanometers discussed above, the area of the quarter circle is (pi)(8²)/4, or 16(pi) square nanometers. One linear nanometer (L2) of surface is now covered by eight square nanometers of oxide (L2 x L = 8). To obtain 16(pi) square nanometers to supply the quarter circle 83, oxide from a region about six nanometers long (ie. 16(pi)/8) must be depleted and contributed into the quarter circle. Hatched area 84 must now be about 6 nanometers long. In contrast, in Example 1, this hatched area was about 1.5 nanometers long. Thus, the relative thinning becomes greater as layer thickness increases.

Therefore, it has been shown in a general fashion why thinning of oxide occurs at a corner. One explanation will now be given of why the invention reduces oxide thinning.

### Why Invention Reduces Thinning One View

From one point of view, the invention reconfigures the silicon surface such that the quarter circle 83 in Figure 23 is broken into several sectors, two of which are shown in Figure 24, which are separated from each other. With multiple, separated sectors 83A, the thinning will be lessened, for two main reasons. First, each sector requires a smaller volume of donated material, and, second, a greater surface area of silicon is involved in making the donations. As to the second reason, in the case of Figure 23, only two regions 86 were involved in making donations to the quarter circle 83. In contrast, in Figure 24, each sector receives donations from two regions 86, making a total of four donating regions. Thus, in Figure 24, the donations are spread over four regions instead of two, and thinning is lessened.

Figure 24 shows a single facet 87 replacing the corner 81. However, multiple facets and multiple sectors can be used, and the principles discussed above still apply. Further, a curved surface can be used, and treated as having multiple facets.

### Second View

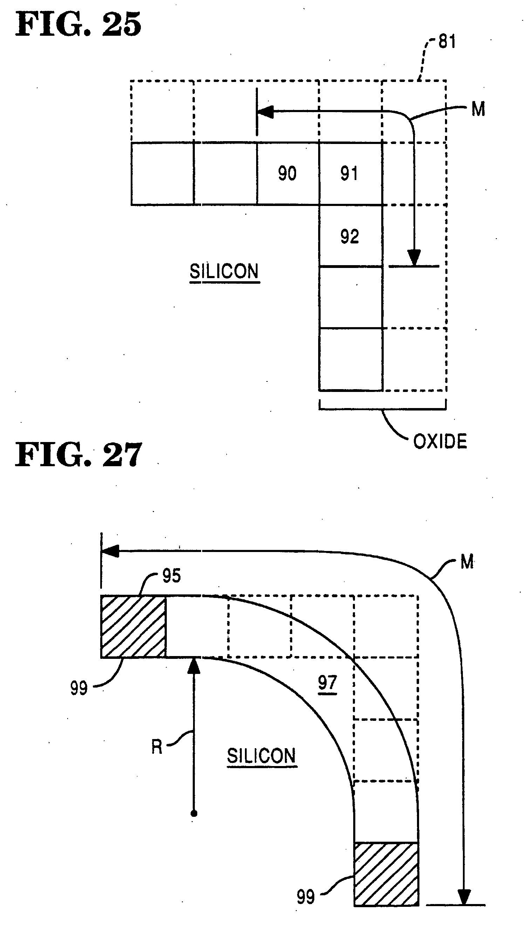

From another point of view, the invention reconfigures the sharp corner such that a larger proportionate volume of silicon supplies the surface area over which thinning otherwise would occur. The proportionality is between the volume supplying the surface and the surface area supplied. Figures 25 and 26 illustrate this concept of proportionate volume.

Figure 25 shows a sharp corner. During oxidation, the silicon enclosed in the cubes having solid walls 88 supplies the oxide layer, as indicated by the respective arrows in Figure 26. For cubes 90A, material migration is only in a direction perpendicular to their surface; each cube 90A supplies only a single phantom cube. However, the three cubes 90 - 92 are required to supply five adjacent phantom cubes in Figure 26. For these cubes, there is lateral (ie, along the surface 78) as well as perpendicular migration. The oxide supplied by these three cubes is thinned. In contrast, the remaining four cubes 90A supply only four phantom cubes; no thinning occurs here.

If the corner is replaced by a curved corner, as shown in Figure 27, a greater proportionate volume (ie, swath 97 plus cubes 99) now supplies the oxide, and thinning is reduced. The concept of a greater proportionate volume will now be explained.

In Figure 25, the volume of cubes 90 - 92 is distributed over a surface area of length M. The length of M is 4 units, and so, assuming the thickness (into the paper) is one unit, the area is 4 square units. The total volume of cubes 90 - 92 is 3 cubic units. Thus, the ratio of surface to volume is 4/3, or 1.33.

The same computation will be made for the rounded corner of Figure 27. The area represented by length M is {1/4 x [(pi) x 8]} + 2, or about 8.3 square units.

The volume of silicon which supplies this area of length M is that within (a) region 97 plus (b) the two hatched cubes 99. Region 97 has a volume of [(pi x 4²) - (pi x 3²)]/4, or about 5.5 cubic units. Adding the two hatched cubes (one cubic unit each) to this volume gives a total volume of about 7.5 cubic units.

Therefore, for Figure 27, a volume of about 7.5 cubic units supplies an area of about 8.3 square units. The ratio of surface area to volume is about 8.3/7.5, or about 1.11. The surface/volume ratio has decreased in Figure 27, as compared with Figure 25, indicating that the oxide layer will be thicker.

Therefore, from this perspective, the invention deceases the ratio of (a) surface area supplied to (b) volume of silicon precursor supplying the area. From a converse perspective, the proportionate volume supplying a given area is increased: under the syrup analogy, the amount of syrup supplying the pan is increased. Similarly, the volume of silicon per unit area of silicon surface to be oxidized is increased.

It is recognized that the computations given above do not predict the exact thickness of oxide which will be obtained. One reason is that the migration pattern is not known and, even if known, will change with such parameters as temperature, reaction time, etc. One result of this lack of knowledge is that the length 86 in Figure 23 of the regions supplying the quarter circle 83 is not known. Nevertheless, the computations are given in order to illustrate the broad principle that oxide thinning occurs at sharp corners.

2. The rounded corner 64 in Figure 7 can be viewed as a flare in the entrance to the trench. The flare removes the sharp corner, indicated by the phantom line 50 in Figure 1C.

3. The sharp corner 53 in Figure 7A can be viewed as a protrusion. When gate oxide is deposited over the protrusion, thinning occurs, as discussed above. The invention blunts the protrusion, by forming it into facets.

4. The rounded (or blunted) corner 64 of Figure 7B can be viewed as an edge of a higher radius of curvature, as compared with the corner 53 in Figure 7A, which has a lower radius of curvature. In theory, a corner has a radius of curvature of zero, and a straight line has an infinite radius.

5. The described method can be viewed as forming a small bird's beak at the edge of the interface 48 in Figure 9 between the pad oxide and the silicon, followed by sealing the edge against further bird's beak formation during field oxide growth. That is, a pre-oxidation is undertaken. After field oxide growth has been completed, the final bird's beak is smaller that which would exist if the field oxide were formed with no sealing nitride present.

The term "bird's beak" is defined in the art. One definition refers to the oxide structure formed below an oxide layer located atop a silicon layer, and having an edge exposed to oxygen which invades along the interface in order to form the beak. The bird's beak decreases in thickness as distance from the edge increases.

In one form of the invention, the preferred radius of curvature of the connecting surface is determined with reference to the oxide layer thickness. That is, if the oxide is extremely thin, a sharp corner may pose no problem, because the quarter circle 83 of Figure 23 is of such a small area that the contributions from neighboring oxide are insignificant. Conversely, if the oxide is thick, the contributions become significant.

It is preferred that the radius of curvature R in Figure 27 be at least 30 nanometers. For faceted surfaces, which are not curved, such as those shown in Figure 24, the term "radius of curvature" can refer to an average radius approximated by a pair of curves 102A and 102B which sandwich the facets.

6. The invention can be viewed as forming a collar of oxide, in the form of the oxide forming the small bird's beak in Figure 10, around the trench 39.

7. Detailed technical specifications for carrying out the steps described above have not been given, because methods of executing these steps are well known in the art.

8. From one point of view, an important aspect of the invention is the attainment of the rounded corner 64 in Figure 7B, prior to formation of the gate oxide layer 52. The steps which produce this rounded corner are one form of the invention.

## Claims

1. A method of processing a semiconductor device having a silicon substrate (30), comprising the steps of forming a pad oxide layer (33) on said substrate (30), forming a trench (39) through said pad oxide layer (33) and into said silicon substrate (30), blunting the corner (53) of the silicon substrate (**30**) found at the sidewall of the trench (39) at the point of interface between the silicon substrate (30) and said pad oxide layer (33) by the formation of rounding oxide (40) at said region, forming a silicon nitride protection layer (70) to extend over said rounding oxide at said region, exposing the base of said trench (39) and thermally growing field oxide (43) in said trench (39), exposing said blunted corner (53) and forming an oxide layer (52) to extend over said blunted comer (53), the method comprising the step of, prior to said step of forming said silicon nitride protection layer (70), partially removing said layer of rounding oxide (40) from the side walls of said trench (39) to form substantially planar and parallel surfaces of the rounding oxide on the side walls of the trench.

## Patentansprüche

1. Verfahren zum Verarbeiten eines Halbleiterbauelementes mit einem Siliziumsubstrat (30), umfassend die folgenden Schritte: Ausbilden einer Kontaktstellenoxidschicht (33) auf dem genannten Substrat (30), Ausbilden eines Grabens (39) durch die genannte Kontaktstellenoxidschicht (33) und in das genannte Siliziumsubstrat (30), Abrunden der Ecke (53) des Siliziumsubstrats (30) an der Seitenwand des Grabens (39) an der Grenzstelle zwischen dem Siliziumsubstrat (30) und der genannten Kontaktstellenoxidschicht (33) durch Ausbilden von Rundungsoxid (40) in der genannten Zone, Ausbilden einer Siliziumnitridschutzschicht (70), so dass sie über das genannte Rundungsoxid in der genannten Zone verläuft, Exponieren des Bodens des genannten Grabens (39) und thermisches Aufwachsenlassen von Feldoxid (43) in dem genannten Graben (39), Exponieren der genannten abgerundeten Ecke (53) und Ausbilden einer Oxidschicht (52), so dass sie über die genannte abgerundete Ecke (53) verläuft, wobei das Verfahren den folgenden Schritt vor dem genannten Schritt des Ausbildens der genannten Siliziumnitridschutzschicht (70) umfasst: teilweises Entfernen der genannten Schicht aus Rundungsoxid (40) von den Seitenwänden des genannten Grabens (39) zur Bildung von im Wesentlichen planaren und parallelen Oberflächen des Rundungsoxids an den Seitenwänden des Grabens.

## Revendications

1. Méthode pour traiter un dispositif semi-conducteur ayant un substrat de silicium (30), comprenant les étapes consistant à former une couche d'oxyde de bourrage (33) sur ledit substrat (30), former une dépression (39) à travers ladite couche d'oxyde de bourrage (33) et dans ledit substrat de silicium (30), émousser le coin (53) du substrat de silicium (30) qui se trouve au niveau de la paroi latérale de la dépression (39) au point d'interface entre le substrat de silicium (30) et ladite couche d'oxyde de bourrage (33) par la formation d'un oxyde d'arrondissage (40) au niveau de ladite région, former une couche de protection au nitrure de silicium (70) devant s'étendre sur ledit oxyde d'arrondissage au niveau de ladite région, exposer la base de ladite dépression (39) et faire croître thermiquement de l'oxyde de champ (43) dans ladite dépression (39), exposer ledit coin émoussé (53) et former une couche d'oxyde (52) devant s'étendre sur ledit coin émoussé (53), la méthode comprenant, préalablement à ladite étape de formation de ladite couche de protection au nitrure de silicium (70), l'étape consistant à retirer partiellement ladite couche d'oxyde d'arrondissage (40) des parois latérales de ladite dépression (39) pour former des surfaces sensiblement planes et parallèles de l'oxyde d'arrondissage sur les parois latérales de la dépression.
